# EUROPEAN PATENT SPECIFICATION

(11) **EP 3 647 797 B1**
(45) Date of publication and mention of the grant of the patent: **05.08.2026**
(21) Application number: 18204435.4
(22) Date of filing: 05.11.2018
(51) Int. Cl.: G01R 31/12, H02S 50/00, H02H 1/00, H02H 3/33, H02H 3/50, H02J 1/10, H02J 3/38, G01R 31/40, H02H 7/26, H02H 3/04, G01R 19/15, H01H 83/14, H02J 13/00, H04B 3/54, H04B 3/56, H02M 1/12

(54) **AN INVERTER COMPRISING MEANS FOR DETECTING ARCING FAULTS IN THE DC SECTION OF A PHOTOVOLTAIC PLANT**
WECHSELRICHTER MIT MITTELS ZUR ERKENNUNG VON LICHTBÖGEN IN EINER FOTOVOLTAIKANLAGE
ONDULEUR COMPRENNANT DES MOYENS POUR LA DÉTECTION D'ARC DANS UNE INSTALLATION PHOTOVOLTAÏQUE

(43) Date of publication of application: 06.05.2020
(73) Proprietor: MARICI Holdings The Netherlands B.V., 3068AX Rotterdam (NL)
(72) Inventor: Mirra, Mirco, I-52028 Terranuova Bracciolini (AR) (IT); Macerini, Sauro, I-52021 Bucine (AR) (IT)
(74) Representative: De Bortoli, Eros

(56) References cited:
- EP-A1- 3 282 532
- WO-A1-2009/073868
- WO-A2-2010/078303
- DE-A1- 102013 108 166
- DE-A1- 102016 119 877

## Description

The present invention relates to an inverter for a photovoltaic plant.

Document EP 3 282 532 A1 is an example of prior art.

As is known, a photovoltaic plant generally includes a DC section, an inverter and an AC section.

The DC section includes one or more strings of photovoltaic panels, each formed by a plurality of photovoltaic panels electrically connected in series, and a DC bus electrically connecting in parallel such strings of photovoltaic panels with the inverter.

The AC section includes an AC bus electrically connecting the inverter with an AC grid.

As is known, inverters for photovoltaic applications are normally equipped with a number of protection devices aimed at ensuring a safe operation of the photovoltaic plant.

Typically, inverters for photovoltaic plants are equipped with arc fault detection devices adapted to detect arc faults in the DC section of the photovoltaic plant. These transduction devices are quite important as the occurrence of arc faults may have severe consequences in photovoltaic plants. As an example, arc faults due to loose connections in the DC electric bus may lead to fire events in the structure (e.g. the rooftop of a building) on which the photovoltaic panels are installed.

In some countries (e.g. in the USA), there are technical regulations requiring photovoltaic plants to be equipped with protection arrangements (commonly known as "Rapid Shutdown Devices" or "RSD") capable of de-energizing the photovoltaic panels in case of need, e.g. upon a manual intervention of an operator or in case of failure of the AC grid.

These protection devices normally intervene at string level by short-circuiting the power terminals of each string of photovoltaic panels upon receiving or failing to receive suitable shutdown control signals.

Inverters for photovoltaic applications are generally equipped with shutdown control devices capable of transmitting suitable shutdown commands to the RSDs when shutdown conditions occur.

As it may be easily understood, due to the presence of the above-mentioned protection arrangements, the design of the DC stage of an inverter for a photovoltaic plant is a rather challenging task to carry out, particular when many electric lines are present.

Currently available design solutions are normally complex and expensive to implement at industrial level.

The main aim of the present invention is to provide an inverter for a photovoltaic plant, which enables the disadvantages described above to be overcome.

Within this aim, another object of the present invention is to provide an inverter, in which mostly required protection devices, in particularly arc fault detection devices and shutdown control devices, are arranged in compact circuit structures at the DC stage of the inverter. Another object of the present invention is to provide an inverter having a DC stage particularly easy to design and inexpensive to produce at industrial level.

This aim and these objects, together with other objects that will be more apparent from the subsequent description and from the accompanying drawings, are achieved, according to the invention, by an inverter, according to claim 1 and the related dependent claims. The invention is set out in the appended set of claims. The embodiments and/or examples of the following description which are not covered by the appended claims are considered as not being part of the present invention.

Further characteristics and advantages of the present invention will be more apparent with reference to the description given below and to the accompanying figures, provided purely for explanatory and non-limiting purposes, wherein:
- Fig. 1 schematically illustrates a photovoltaic plant including an inverter, according to the present invention;
- Fig. 2 schematically illustrates a photovoltaic string in the photovoltaic plant of Fig. 1;
- Figs. 3-5 schematically illustrate the DC section of the inverter, according to the present invention;

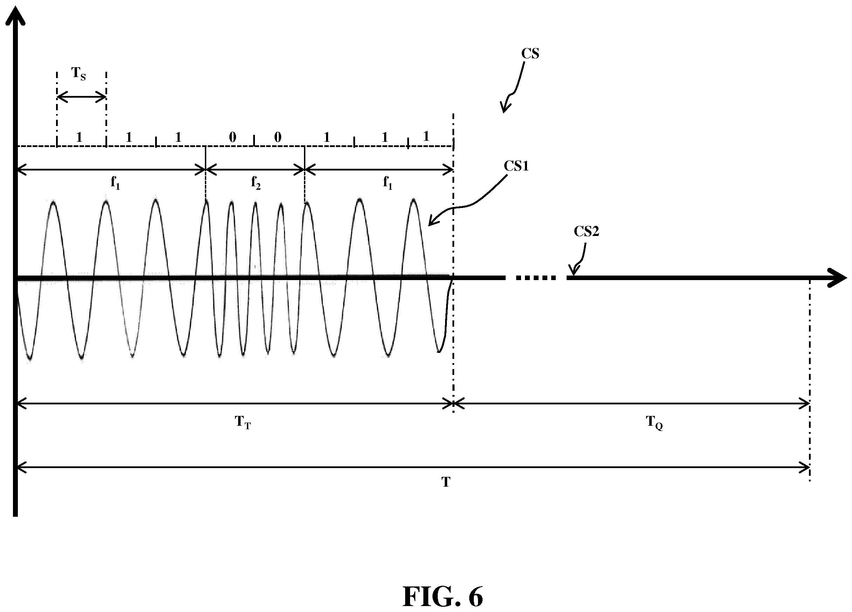

- Fig. 6 schematically illustrates an example of signal transmitted along the DC electric lines of the inverter, according to the present invention.

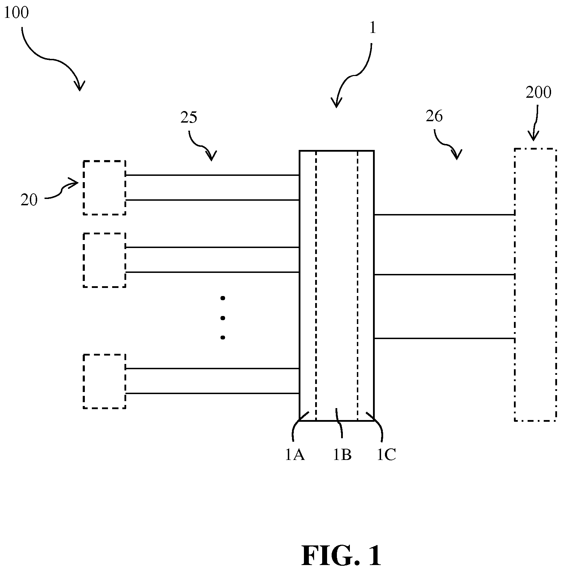

With reference to figure 1, the present invention relates to an inverter 1 for a low voltage photovoltaic plant 100.

For the sake of clarity, it is specified that the term "low voltage" refers to operating voltages lower than 1 kV AC and 1.5 kV DC.

The photovoltaic plant 100 comprises a DC section including one or more strings 20 of photovoltaic panels and a DC electric bus 25 electrically connected with said strings of photovoltaic panels.

The photovoltaic plant 100 comprises the inverter 1 electrically connected with the DC electric bus 25.

In general, the inverter 1 is adapted to manage the DC/AC conversion of DC electric power provided by the photovoltaic panels and deliver the AC electric power so obtained to an AC grid 200, e.g. the mains or an electric power distribution grid fed by the photovoltaic plant 100.

The photovoltaic plant 100 further comprises an AC section including an AC electric bus 26 electrically connecting the inverter 1 with the AC grid 200.

In general, most of the components of the above-mentioned DC and AC sections of the photovoltaic plant 100 may be of known type and, hereinafter, they will be described only with reference to the aspects of interest of the invention, for the sake of brevity.

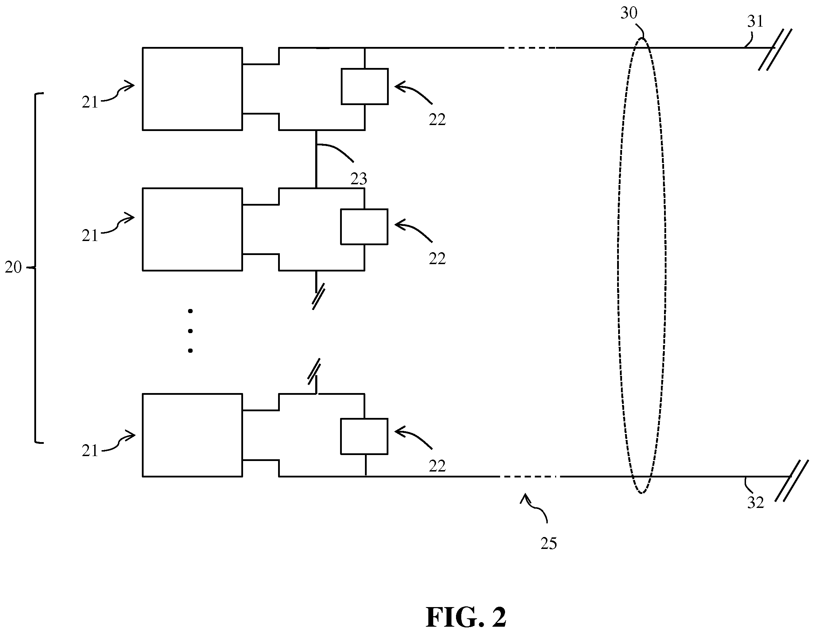

In figure 2, a photovoltaic string 20 of the photovoltaic plant 100 is schematically illustrated.

A photovoltaic string 20 comprises a plurality of photovoltaic panels 21 electrically connected in series one to another by a power bus 23. The number of photovoltaic panels electrically connected in series basically depends on the installation requirements of the photovoltaic plant 100.

Conveniently, the photovoltaic string 20 comprises one or more Rapid Shutdown Devices (RSDs) 22 operatively associated with the photovoltaic panels 21. The RSDs 22 are adapted to cause the shutdown of each photovoltaic panel 22 by lowering the voltage difference between the power terminals of this latter (e.g. by short-circuiting said power terminals) upon receiving or, preferably, failing to receive suitable shutdown control signals.

The photovoltaic string 20 comprises a RSD 22 for each photovoltaic panel 21, as shown in figure 1. However, different arrangements are available to the skilled person.

It is important to notice that the RSDs 22 of each photovoltaic string 20 are electrically connectable with a corresponding DC input channel of the inverter 1 via the above-mentioned power bus 23 and DC bus 25.

Most of the components of the photovoltaic string 20, for example the photovoltaic panels 21, the RSDs 22 and the electric power bus 23 may be of known type and, hereinafter, they will be described only with reference to the aspects of interest of the invention, for the sake of brevity.

The inverter 1 comprises a DC stage 1A, a DC/AC conversion stage 1B and an AC stage 1C. At the DC/AC conversion stage 1B, the inverter 1 comprises a DC/AC main switching converter and other electronic devices or circuits to carry out a DC/AC conversion of the DC electric power received at the DC stage 1A.

At the AC stage 1C, the inverter 1 comprises one or more electric lines (not shown) electrically connectable with corresponding ports of the AC grid via the AC bus 26.

In general, the most of the components of the DC/AC conversion stage 1B and the AC stage 1C may be of known type and, hereinafter, they will be described only with reference to the aspects of interest of the invention, for the sake of brevity.

At the DC stage 1A, the inverter 1 comprises one or more electric lines 30, each of which is electrically connectable to a corresponding photovoltaic string 20 via the DC bus 25.

Each electric line 30 comprises a plurality of line conductors 31, 32, conveniently two line conductors 31, 32 having different voltage polarities.

Each electric line 30 is thus adapted to form a corresponding DC input channel for the inverter 1, which is electrically connected to a corresponding photovoltaic string 20 through the DC electric bus 25 and which is capable of providing a DC current to the AC/DC conversion stage 1B (figures 2-3).

The number of electric lines 30 (DC input channels) basically depends on the number of photovoltaic strings 20 included in the photovoltaic plant 100.

Preferably, the photovoltaic plant 100 comprises a plurality of photovoltaic strings 20 (e.g. one or more tens of photovoltaic strings). In this case, the inverter 1 is conveniently of the multi-channel type and it will comprise a plurality of electric lines 30 arranged as illustrated above.

According to the invention, at the DC stage 1A, the inverter 1 comprises a coupling transformer 4 operatively coupled with the electric lines 30.

The coupling transformer 4 comprises a first winding arrangement 5 and a second winding arrangement 6 magnetically coupled one with another.

Preferably, the coupling transformer 4 is configured as an amperometric transformer (configured as magnetic coil or as a Rogowski coil) having a single magnetic circuit enchained with the first and second winding arrangements 51, 62, 63 to magnetically couple these latter.

Preferably, such a magnetic circuit is formed by a single piece of magnetic material (e.g. with a toroidal shape) having a relatively low magnetic permeability (e.g. lower than or equal to 150) to avoid or reduce the occurrence of saturation phenomena.

As an alternative, such a magnetic circuit may be formed by shaped pieces of magnetic material (magnetic core), which may be arranged to form one or more airgaps along the magnetic circuit.

As a further alternative, such a magnetic circuit may be formed by one or more shaped pieces of non-magnetic material (Rogowski coil with non-magnetic core). These pieces of non-magnetic material may be arranged to form one or more airgaps along the magnetic circuit. As a further alternative, such a magnetic circuit may be a magnetic flux path fully realized in air (Rogowski coil in air).

According to the invention, the first winding arrangement 5 comprises one or more first winding conductors 51. Each first winding conductor 51 of the coupling transformer 4 is electrically connected with a line conductor 31, 32 of a corresponding electric line 30.

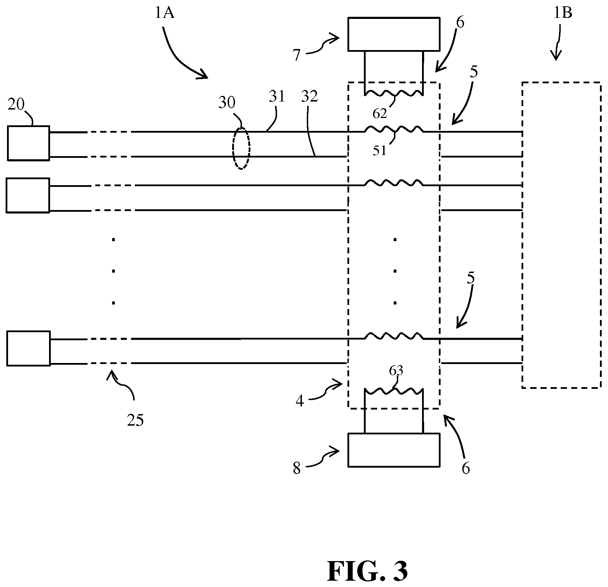

According to a possible arrangement illustrated in figure 3, the coupling transformer 4 comprises a sole first winding conductor 51 operatively associated to each electric line 30. In this case, each first winding conductor 51 is electrically connected only with a line conductor 31 (e.g. having a positive voltage polarity) or with a line conductor 32 (e.g. having a positive voltage polarity) of each DC electric line 30. The remaining line conductors of each electric line 30, which are not electrically connected with corresponding first winding conductors 51, are conveniently arranged externally to the coupling transformer 4 to be not unchained with the magnetic circuit of this latter.

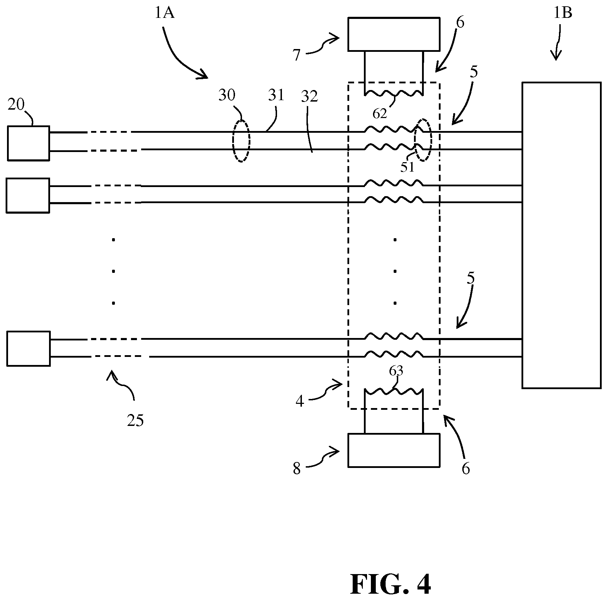

According to an alternative possible arrangement illustrated in figure 4, the coupling transformer 4 comprises a group (e.g. a pair) of first winding conductors 51 operatively associated with each electric line 30. In this case, each group (e.g. a pair) of first winding conductors 51 is electrically connected only with a corresponding group (e.g. a pair) of line conductors 31, 32 of each electric line 30. Possible remaining line conductors of each electric line 30, which are not electrically connected with corresponding first winding conductors 51, are conveniently arranged externally to the coupling transformer 4 to be not unchained with the magnetic circuit of this latter.

According to the invention, the second winding arrangement 6 of the coupling transformer 4 comprises one or more winding conductors 62, 63 magnetically coupled with the first winding conductors 51 of the first winding arrangement 5.

In principle, the second winding arrangement 6 may comprise any number of winding conductors, according to the needs.

According to the embodiments of the invention shown in the cited figures, the second winding arrangement 6 comprises a second winding conductor 62 and a third winding conductor 63.

According to the invention, the second winding arrangement 6 is adapted to provide in output first signals DS of AC type, which are indicative of AC currents flowing along the DC electric lines 30 by exploiting the magnetic coupling with the first winding arrangement 5 provided by the magnetic circuit of the coupling transformer 4.

In normal operation, DC currents (load currents) flow along the conductors 31, 32 of the electric lines 30.

However, also AC noise currents may flow overlapped with said DC currents. Such AC noise currents, which generally have a well-defined spectral content, are normally generated by electric or electronic components of the inverter or, more in general, of the photovoltaic plant 100.

When an arc fault occurs, AC arc currents flow along the conductors 31, 32 of the electric lines 30 (overlapped with said DC currents and said AC noise currents). Such AC arc currents, which generally have a broadband spectral content (pink noise), are normally generated due to the turbulences of the arc plasma formed during the arc fault and due to other factors linked to the occurring arc phenomenon.

In view of the above, the second winding conductor 62 is evidently adapted to provide in output first signals DS that can be processed to determine whether AC currents circulating along the electric lines 30 are due to normal noise sources or are indicative of the occurrence of arc fault events.

The first signals DS are conveniently formed by suitable analog AC current signals. The first signals DS are thus transduction signals of certain physical quantities (i.e. the AC currents circulating along the DC electric lines 30). Therefore, they have a completely different nature with respect test signals, data signals or control signals, which are normally exchanged between mutually interacting electronic devices.

According to the embodiments of the invention shown in the cited figures, the second winding arrangement 6 comprises the second winding conductor 62 adapted to provide the first signals DS indicative of AC currents flowing along the DC electric lines 30 by exploiting the magnetic coupling with the first conductors 51 of the first winding arrangement 5 provided by the magnetic circuit of the coupling transformer 4.

Preferably, the inverter 1 comprises an arc fault detection arrangement 7 operatively coupled with the second winding arrangement 6, preferably with the second winding conductor 62 as shown in the cited figures.

In general, the arc fault arrangement 7 is adapted to determine the presence of possible arc fault events at the electric lines 30, at the DC bus 25 and at the photovoltaic strings 20 connected thereto.

Preferably, the arc fault detection arrangement 7 comprises an arc fault detection module 70 operatively coupled with the second winding arrangement 6, preferably with the second winding conductor conductor 62.

Preferably, the arc fault detection module 70 is adapted to carry out arc fault detection functionalities basing on the first signals DS provided by the second winding arrangement 6, preferably by the second winding conductor 62.

Said arc fault detection functionalities (which may be of known type) may include, for example, the processing of the first signals DS to determine the presence of possible arc currents (which are thus indicative of incoming or occurring arc faults) by selectively identifying them basing on a spectral content analysis.

In general, most of said arc fault detection functionalities may be of known type and they will not here described in more details for the sake of brevity.

The arc fault detection module 70 is adapted to provide in output, upon the determination of arc fault conditions, control signals CP indicative of the presence of an arc fault in the electric lines 30 to other control devices or protection devices (e.g. protection switches - not shown) adapted to cause the interruption the current flow along the DC electric lines 30.

Preferably, the arc fault detection module 70 comprises a first filtering module 71 operatively coupled with the second winding arrangement 6, preferably with the second winding conductor 62.

The first filtering module 71 is adapted to filter (i.e. to attenuate or cut) AC signal components of the first signals DS, which have a frequency out of a given frequency band. As an example, the filtering module 71 may be configured to filter AC signal components of the first signals DS, which have operating frequencies not included in the frequency band between 50 kHz and 150 kHz.

In a practical implementation (of analog type) of the embodiments shown in the cited figures, the filtering module 71 may be a band-pass RLC filter circuit arranged in parallel with the second winding conductor 62 to receive the transductions signals DS provided by this latter and filter these signals before they are processed by the arc fault detection module 70.

According to the invention, the second winding arrangement 6 is adapted to exchange second signals CS, TS of the AC type with the line conductors 31, 32 of the DC electric lines 30 by exploiting the magnetic coupling with said first winding arrangement.

According to the embodiments of the invention shown in the cited figures, the second winding arrangement 6 comprises the third winding conductor 63 adapted to exchange the second signals CS, TS with the line conductors 31, 32 of the DC electric lines 30.

In principle, the second signals CS, TS may be of any type (for example test signals, data signals or control signals) and they can be injected along the DC electric lines 30 by the second winding arrangement 6 or by remote devices coupled with said DC electric lines.

According to the invention, the second winding arrangement 6 is adapted to inject AC control signals CS (preferably formed by suitable AC current signals) along the line conductors of the DC electric lines by exploiting the magnetic coupling between the first and second winding arrangements provided by the magnetic circuit of the coupling transformer 4.

In practice, the second winding arrangement 6 is adapted to receive in input the control signals CS and inject these signals along the electric lines 30 by exploiting the magnetic coupling provided by the coupling transformer 4.

It is important to notice that the control signals CS transmitted by the second winding arrangement 6 are injected in parallel along all the electric lines 30 coupled with the coupling transformer 4. In this way, the control signals CS are transmitted in parallel to the photovoltaic strings 20 electrically connected with the DC input channels 30. The control signals CS can thus be received by electronic devices electrically connected with the power bus 23 of each photovoltaic string 30, in particular by the RSDs 22.

According to the embodiments of the invention shown in the cited figures, the second winding arrangement 6 comprises the third winding conductor 63 adapted to inject the control signals CS (preferably formed by suitable AC current signals) along the line conductors of the DC electric lines by exploiting the magnetic coupling with the first conductors 51 of the first winding arrangement 6 provided by the magnetic circuit of the coupling transformer 4.

According to the invention, the inverter 1 comprises a shutdown control arrangement 8 operatively coupled with the second winding arrangement 6, preferably with the third winding conductor 63.

In general, the shutdown control arrangement 8 is adapted to control RSDs 22 included in the photovoltaic strings 20 by providing the control signals CS to the second winding arrangement 6, preferably to the third winding conductor 63. The control signals CS are then injected by the second winding arrangement 6, preferably by the third winding conductor 63, along the electric lines 30 to be received by the RSDs 22.

The shutdown control arrangement 8 comprises a shutdown control module 80 operatively coupled with the second winding arrangement 6, preferably with the third winding conductor 63.

The shutdown control module 80 is adapted to inject the control signals CS to the second winding arrangement 6, preferably to the third winding conductor 63, to control the RSDs 22 included in the photovoltaic strings 20 in such a way to cause the intervention of the RSDs 22 included in the photovoltaic strings 20 in case of need.

According to a preferred embodiment of the invention, the shutdown control module 80 and the RSDs are configured to interact according to a "normally-linked" interaction mode.

The shutdown control module 80 is configured to continuously inject the control signals CS during normal operation of the photovoltaic plant 100 and interrupt the transmission of the control signals CS when the shutdown of the photovoltaic panels 21 is requested.

On the other hand, the RSDs are configured to intervene to cause the shutdown the photovoltaic panels 21 when they do not receive the control signals CS transmitted by the shutdown control module 80 anymore.

This solution allows improving safety conditions of the photovoltaic plant 100 as the rapid shutdown devices 22 can intervene even when the shutdown control module 80 is subject to a fault and it is no more able to inject the control signals CS.

Preferably, the shutdown control module 80 is configured to interrupt the transmission of the control signals CS upon receiving a command signals IS from an external device (not shown), e.g. a control unit of the inverter or a control device manually activated by a user.

According to other embodiments of the invention, the shutdown control module 80 and the RSDs may be configured to interact according to a "normally-unlinked" interaction mode. The shutdown control module 80 is configured to inject the control signals CS only when the shutdown of the photovoltaic panels 21 is requested, e.g. upon receiving a command signals IS from an external device (not shown), e.g. a control unit of the inverter or a control device manually activated by a user.

On the other hand, the RSDs are configured to intervene to cause the shutdown the photovoltaic panels 21 upon receiving the control signals CS transmitted by the shutdown control module 80.

Preferably, the shutdown control arrangement 8 comprises a second filtering module 82 operatively coupled with the second winding arrangement 6, preferably with the third winding conductor 63.

The second filtering module 82 is adapted to filter high-frequency AC signal components of the control signals CS transmitted by the shutdown control module 80.

In a practical implementation (of analog type) of the embodiments shown in the cited figures, the filtering module 82 may be a low-pass RC filter circuit arranged in parallel with the third winding conductor 63 to receive the control signals CS transmitted by the shutdown control module 80.

Preferably, the shutdown control arrangement 8 comprises a third filtering module 83 operatively coupled with the second winding arrangement 6, preferably with the third winding conductor 63.

The third filtering module 83 is adapted to filter DC signal components of the control signals CS transmitted by the shutdown control module 80.

In a practical implementation (of analog type) of the embodiments shown in the cited figures, the filtering module 83 may be a high-pass capacitive filter circuit arranged in series with the third winding conductor 63 to receive the control signals CS transmitted by the shutdown control module 80.

Preferably, the shutdown control module 80 is configured to provide control signals CS having pulsed signal components having a variable frequency. However, the control signals CS will have sine-wave signal components when injected along the electric lines 30 by the third winding 63 due to the filtering action carried out by the filtering modules 82 and 83. Preferably, the shutdown control arrangement 8 comprises an adapter module 81 operatively coupled with the third winding conductor 63 and adapted to provide analog front-end (AFE) functionalities.

In a practical implementation of the embodiments shown in the cited figures, the adapted module 81 may comprise filtering circuits, amplification circuits, A/D and D/A converter circuits, etc. to provide impedance matching and convert digital signals (transmitted by the shutdown control module 80) into analog signals to be received and injected by the third winding conductor 63.

The above-mentioned modules 70, 71, 80, 81, 82, 83 may be industrially implemented in an analog and/or digital manner.

If they are implemented in analog manner, they will comprise electronic circuits suitably arranged to perform the functions of provided for said modules. Said electronic circuits may form separated circuit units or may be at least partially integrated in one or more circuit units. If they are implemented in a digital manner, they will comprise suitably arranged software instructions stored in a medium and executable by one or more computerised units (e.g. microprocessors) to perform the functions provided for said modules.

Preferably, the above-mentioned modules 71, 81, 82, 83 are implemented in an analog manner, e.g. arranged on a same control board 11 of the inverter 1.

Preferably, the above-mentioned modules 70, 80 are implemented in a digital manner, preferably by digital signal processing means (e.g. one or more microprocessors), for example arranged the above mentioned control board of the inverter 1.

In principle, the second AC signals exchanged by the second winding arrangement 6 may have any shape any frequency and shape and they may travel along the DC electric lines 30 at any time.

However, in some cases, the second AC signals exchanged by the second winding arrangement 6 may be suitably designed to avoid undesired interferences with the arc fault detection functionalities carried out by the arc fault detection module 70 due to the magnetic coupling provided by the coupling transformer 4.

According to a preferred embodiments of the invention (in which the shutdown control module 80 and the RSDs interact according to a "normally-linked" interaction mode), the control signals CS transmitted by second winding arrangement 6, preferably by the third winding conductor 63, along the electric lines 30 are periodic signals with a given period T (e.g. T=1168 ms).

Preferably, each period T of the control signals CS includes an active sub-period T_{T} and a stand-by sub-period T_{Q}, the duration of which is calculated in such a way to obtain a predefined duty-cycle value DC.

As an example, the active sub-period T_{T} and the stand-by sub-period T_{Q} may have a duration of 168 ms and 900 ms, respectively, to obtain a duty-cycle value DC = (T_{T} / T) = 0,15. Preferably, during the active sub-period T_{T}, the control signals CS include a frequency modulated signal component CS1 (preferably with a sine waveform as illustrated above). Preferably, the signal component CS1 is a BFSK-modulated signal component.

In this case, the component signal CS1 is conveniently formed by a signal that may take a first modulation frequency f₁ (e.g. f₁ = 131,25 KHz) or a second modulation frequency f₂ (e.g. f₂ = 143,75 KHz) at sub-sequent time slots T_{S} (e.g. T_{S} = 5-12 ms) included in the active sub-period T_{T} depending on the information content to be transmitted.

In accordance with the general principles of the BFSK signal modulation, for each time slot T_{S}, the transmission of a modulated signal component CS1 with a first modulation frequency f₁ is equivalent to the transmission of a "high" logic value (information bit = 1) whereas the transmission of a modulated signal component CS1 with a second modulation frequency f₂ is equivalent to the transmission of a "low" logic value (information bit = 0). In this way, the signal component CS1 may provide information content when transmitted along the electric lines 30.

Preferably, during the stand-by sub-period T_{Q}, the control signals CS include a null signal component. In practice, during the stand-by sub-period T_{Q}, no signal components are transmitted along the electric lines 30.

Preferably, during the active sub-period T_{T}, the arc fault detection module 70 is put in a stand-by mode in such a way to avoid that the transmission of the control signals CS along the electric lines 30 somehow interfere with the arc fault detection functionalities carried out by the arc fault detection module 70 due to the magnetic coupling provided by the coupling transformer 4.

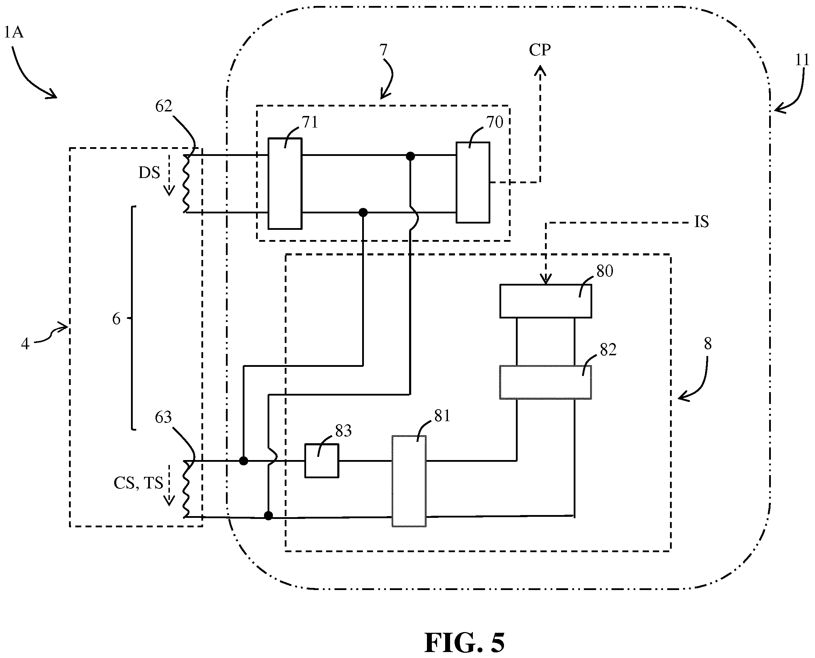

According to an embodiment of the invention (figure 5), the second winding arrangement 6 is adapted to inject AC test signals TS along the line conductors of the electric lines 30 by exploiting the magnetic coupling between said first and second winding arrangements.

Preferably, the test signals TS (preferably formed by current signals) are AC signals with broad band spectral content (pink noise) and are transmitted along the electric lines 30 to simulate the presence of arc fault currents along said electric lines. In this way, the test signals TS may be conveniently detected by the second winding arrangement 6 and used to test the arc fault detection functionalities provided by the arc fault detection arrangement 7.

In principle, the test signals TS may be provided by a dedicated signal generator operatively with the second winding arrangement 6.

Preferably, however, the arc fault detection module 70 is adapted to provide the test signals TS.

According to the embodiments of the invention shown in the cited figures, the second winding arrangement 6 comprises the third winding conductor 63 adapted to inject the test signals TS along the line conductors of the DC electric lines by exploiting the magnetic coupling with the first conductors 51 of the first winding arrangement 6 provided by the magnetic circuit of the coupling transformer 4.

In this case, the arc fault detection module 70 is preferably operatively coupled with the third winding conductor 63 to provide the test signals TS to be injected along the electric lines 30. The present invention allows achieving the intended aims and objects.

The arrangement of a single coupling transformer 4 allows an easy transduction of AC currents flowing along the electric lines 30 and a simple exchange of AC signals (e.g. the control signals CS) with the photovoltaic strings 20 along the electric lines 30.

This solution allows achieving improved circuit integration between the arc fault detection arrangement 7 and the shutdown control arrangement 8, which may be suitably designed on a single control board 11.

Additionally, control signals CS to control the RSDs of the photovoltaic strings 20 may be suitably transmitted along the electric lines 30 and the DC bus 25 without the need of dedicated transmission lines as in currently available solutions of the state of the art.

The solution provided by the present invention thus provides relevant advantages in terms of size reduction and simplification of the circuital layout of the DC stage of the inverter 1 with respect to known solutions of the state of the art.

The inverter, according to the invention, thus has a DC stage particularly easy and cheap to design and implement at industrial level.

## Claims

1. An inverter (1) for a photovoltaic plant (100), said inverter comprising a plurality of DC electric lines (30) electrically connectable to corresponding photovoltaic strings (20) of said photovoltaic plant, each photovoltaic string comprising a plurality of photovoltaic panels (21) and one or more shut-down devices (22) to which said DC electric lines (30) are electrically connectable, said shut-down devices being adapted to cause a shut-down of the photovoltaic panels (21) of said photovoltaic strings by lowering a voltage difference at power terminals of said photovoltaic panels, each DC electric line comprising a plurality of line conductors (31, 32), said inverter comprising a coupling transformer (4) having a first winding arrangement (5) and a second winding arrangement (6) magnetically coupled one with another, said first winding arrangement comprising one or more first winding conductors (51), each electrically connected with a line conductor (31, 32) of a corresponding electric line, said second winding arrangement comprising one or more winding conductors (62, 63) magnetically coupled with said first winding conductors, said second winding arrangement being adapted to provide first signals (DS) indicative of AC currents flowing along said DC electric lines (30), wherein said inverter comprises an arc fault detection arrangement (7) operatively coupled with said second winding arrangement (6) and comprising an arc fault detection module (70) adapted to receive and process said first signals (DS) to carry out arc fault detection functionalities basing on said first signals (DS);
wherein said second winding arrangement is adapted to receive and inject AC shutdown control signals (CS) for the shutdown devices (22) of said photovoltaic strings, said control signals being injected in parallel along all the DC electric lines (30) coupled with said coupling transformer,
wherein said inverter further comprises a shutdown control arrangement (8) operatively coupled of said second winding arrangement (6) and comprising a shutdown control module (80) operatively coupled with said second winding arrangement (6) and adapted to provide said shutdown control signals (CS),
wherein said shutdown control module (80) is configured to transmit continuously said shutdown control signals (CS) during normal operation of said photovoltaic plant (100) and to interrupt the transmission of said shutdown control signals, when the shutdown of photovoltaic panels (21) of said photovoltaic plant is required.

2. Inverter, according to claim 1, **characterized in that** said arc fault detection arrangement (7) comprises a first filtering module (71) adapted to filter AC signal components of said first signals (DS), which have frequencies not included in a given frequency band.

3. Inverter, according to one of the previous claims, **characterized in that** said shutdown control arrangement (8) comprises a second filtering module (82) adapted to filter high-frequency signal components of said shutdown control signals (CS).

4. Inverter, according to claim 3, **characterized in that** said shutdown control arrangement (8) comprises a third filtering module (83) adapted to filter DC signal components of said shutdown control signals (CS).

5. Inverter, according to one of the claims from 3 to 4, **characterized in that** said shutdown control arrangement (8) comprises an adapter module (81) adapted to provide analog front-end functionalities.

6. Inverter, according to one of the previous claims, **characterized in that** said shutdown control signals (CS) are periodic signals, a period (T) of said shutdown control signals including an active sub-period (T_{T}), in which said shutdown control signals include a BFSK-modulated signal component, and a stand-by sub-period (T_{Q}), in which said shutdown control signals include a null signal component, the duration of said active sub-period (T_{T}) and of said stand-by sub-period (T_{Q}) being calculated according to a predefined duty-cycle value (DC).

7. Inverter, according to one of the previous claims, **characterized in that** said second winding arrangement (6) is adapted to inject AC test signals (TS) along the line conductors of said DC electric lines.

8. Inverter, according to claim 7, **characterized in that** said arc fault detection module (70) is adapted to provide said AC test signals (TS) to said second winding arrangement (6).

9. Inverter, according to one or more of the previous claims, **characterized in that** said second winding arrangement (6) comprises a second winding conductor (62) adapted to provide said first signals (DS) indicative of AC currents flowing along said DC electric lines (30) and a third winding conductor (63) adapted to exchange said second signals (CS, TS) along the line conductors (31, 32) of said DC electric lines (30).

10. A photovoltaic plant (100) **characterized in that** it comprises an inverter (1), according to one of the previous claims.

## Patentansprüche

1. Wechselrichter (1) für eine Photovoltaikanlage (100), wobei der Wechselrichter eine Vielzahl von elektrischen DC-Leitungen (30) umfasst, die elektrisch mit entsprechenden Photovoltaiksträngen (20) der Photovoltaikanlage verbindbar sind, wobei jeder Photovoltaikstrang eine Vielzahl von Photovoltaikmodulen (21) und eine oder mehrere Abschaltvorrichtungen (22) umfasst, mit denen die elektrischen DC-Leitungen (30) elektrisch verbindbar sind, wobei die Abschaltvorrichtungen dazu eingerichtet sind, ein Abschalten der Photovoltaikmodule (21) der Photovoltaikstränge durch Verringern einer Spannungsdifferenz an Leistungsanschlüssen der Photovoltaikmodule zu bewirken, wobei jede elektrische DC-Leitung eine Vielzahl von Leitungsleitern (31, 32) umfasst, wobei der Wechselrichter einen Kopplungstransformator (4) mit einer ersten Wicklungsanordnung (5) und einer zweiten Wicklungsanordnung (6) umfasst, die magnetisch miteinander gekoppelt sind, wobei die erste Wicklungsanordnung einen oder mehrere erste Wicklungsleiter (51) umfasst, die jeweils elektrisch mit einem Leitungsleiter (31, 32) einer entsprechenden elektrischen Leitung verbunden sind, wobei die zweite Wicklungsanordnung einen oder mehrere Wicklungsleiter (62, 63) umfasst, die magnetisch mit den ersten Wicklungsleitern gekoppelt sind, wobei die zweite Wicklungsanordnung dazu eingerichtet ist, erste Signale (DS) bereitzustellen, die AC-Ströme angeben, die entlang der elektrischen DC-Leitungen (30) fließen,
wobei der Wechselrichter eine Lichtbogenfehlerdetektionsanordnung (7) umfasst, die operativ mit der zweiten Wicklungsanordnung (6) gekoppelt ist und ein Lichtbogenfehlerdetektionsmodul (70) umfasst, das dazu eingerichtet ist, die ersten Signale (DS) zu empfangen und zu verarbeiten, um Lichtbogenfehlerdetektionsfunktionalitäten basierend auf den ersten Signalen (DS) auszuführen;
wobei die zweite Wicklungsanordnung dazu eingerichtet ist, AC-Abschaltsteuersignale (CS) für die Abschaltvorrichtungen (22) der Photovoltaikstränge zu empfangen und zu injizieren, wobei die Steuersignale entlang aller elektrischen DC-Leitungen (30), die mit dem Kopplungstransformator gekoppelt sind, parallel injiziert werden,
wobei der Wechselrichter ferner eine Abschaltsteueranordnung (8) umfasst, die operativ mit der zweiten Wicklungsanordnung (6) gekoppelt ist und ein Abschaltsteuermodul (80) umfasst, das operativ mit der zweiten Wicklungsanordnung (6) gekoppelt ist und dazu eingerichtet ist, die Abschaltsteuersignale (CS) bereitzustellen,
wobei das Abschaltsteuermodul (80) dazu ausgelegt ist, die Abschaltsteuersignale (CS) während des normalen Betriebs der Photovoltaikanlage (100) kontinuierlich zu übertragen und die Übertragung der Abschaltsteuersignale zu unterbrechen, wenn das Abschalten von Photovoltaikmodule (21) der Photovoltaikanlage erforderlich ist.

2. Wechselrichter nach Anspruch 1, **dadurch gekennzeichnet, dass** die Lichtbogenfehlerdetektionsanordnung (7) ein erstes Filtermodul (71) umfasst, das dazu eingerichtet ist, AC-Signalkomponenten der ersten Signale (DS) zu filtern, die Frequenzen aufweisen, die nicht in einem gegebenen Frequenzband enthalten sind.

3. Wechselrichter nach einem der vorhergehenden Ansprüche, **dadurch gekennzeichnet, dass** die Abschaltsteueranordnung (8) ein zweites Filtermodul (82) umfasst, das dazu eingerichtet ist, hochfrequente Signalkomponenten der Abschaltsteuersignale (CS) zu filtern.

4. Wechselrichter nach Anspruch 3, **dadurch gekennzeichnet, dass** die Abschaltsteueranordnung (8) ein drittes Filtermodul (83) umfasst, das dazu eingerichtet ist, DC-Signalkomponenten der Abschaltsteuersignale (CS) zu filtern.

5. Wechselrichter nach einem der Ansprüche 3 bis 4, **dadurch gekennzeichnet, dass** die Abschaltsteueranordnung (8) ein Adaptermodul (81) umfasst, das dazu eingerichtet ist, analoge Frontend-Funktionalitäten bereitzustellen.

6. Wechselrichter nach einem der vorhergehenden Ansprüche, **dadurch gekennzeichnet, dass** die Abschaltsteuersignale (CS) periodische Signale sind, wobei eine Periode (T) der Abschaltsteuersignale eine aktive Teilperiode (T_{T}) beinhaltet, in der die Abschaltsteuersignale eine BFSK-modulierte Signalkomponente beinhalten, und eine Standby-Teilperiode (T_{Q}) beinhaltet, in der die Abschaltsteuersignale eine Nullsignalkomponente beinhalten, wobei die Dauer der aktiven Teilperiode (T_{T}) und der Standby-Teilperiode (T_{Q}) gemäß einem vordefinierten Tastverhältniswert (DC) berechnet wird.

7. Wechselrichter nach einem der vorhergehenden Ansprüche, **dadurch gekennzeichnet, dass** die zweite Wicklungsanordnung (6) dazu eingerichtet ist, AC-Testsignale (TS) entlang der Leitungsleiter der elektrischen DC-Leitungen zu injizieren.

8. Wechselrichter nach Anspruch 7, **dadurch gekennzeichnet, dass** das Lichtbogenfehlerdetektionsmodul (70) dazu eingerichtet ist, die AC-Testsignale (TS) an die zweite Wicklungsanordnung (6) zu liefern.

9. Wechselrichter nach einem oder mehreren der vorhergehenden Ansprüche, **dadurch gekennzeichnet, dass** die zweite Wicklungsanordnung (6) einen zweiten Wicklungsleiter (62), der dazu eingerichtet ist, die ersten Signale (DS) bereitzustellen, die AC-Ströme angeben, die entlang der elektrischen DC-Leitungen (30) fließen, und einen dritten Wicklungsleiter (63), der dazu eingerichtet ist, die zweiten Signale (CS, TS) entlang der Leitungsleiter (31, 32) der elektrischen DC-Leitungen (30) auszutauschen, umfasst.

10. Photovoltaikanlage (100), **dadurch gekennzeichnet, dass** sie einen Wechselrichter (1) nach einem der vorhergehenden Ansprüche umfasst.

## Revendications

1. Onduleur (1) pour une centrale photovoltaïque (100), ledit onduleur comprenant une pluralité de lignes électriques à courant continu (30) raccordables électriquement à des chaînes photovoltaïques (20) correspondantes de ladite centrale photovoltaïque, chaque chaîne photovoltaïque comprenant une pluralité de panneaux photovoltaïques (21) et un ou plusieurs dispositifs d'arrêt (22) auxquels sont raccordables électriquement lesdites lignes électriques à courant continu (30), lesdits dispositifs d'arrêt étant conçus pour provoquer un arrêt des panneaux photovoltaïques (21) desdites chaînes photovoltaïques par abaissement d'une différence de tension aux bornes de puissance desdits panneaux photovoltaïques, chaque ligne électrique à courant continu comprenant une pluralité de conducteurs de ligne (31, 32), ledit onduleur comprenant un transformateur de couplage (4) ayant un premier agencement d'enroulement (5) et un second agencement d'enroulement (6) couplés magnétiquement l'un à l'autre, ledit premier agencement d'enroulement comprenant un ou plusieurs premiers conducteurs d'enroulement (51), chacun étant électriquement connecté à un conducteur de ligne (31, 32) d'une ligne électrique correspondante, ledit second agencement d'enroulement comprenant un ou plusieurs conducteurs d'enroulement (62, 63) couplés magnétiquement auxdits premiers conducteurs d'enroulement, ledit second agencement d'enroulement étant conçu pour fournir des premiers signaux (DS) indiquant des courants alternatifs circulant le long desdites lignes électriques à courant continu (30),
ledit onduleur comprenant un agencement de détection de défaut d'arc (7) couplé fonctionnellement avec ledit second agencement d'enroulement (6) et comprenant un module de détection de défaut d'arc (70) adapté pour recevoir et traiter lesdits premiers signaux (DS) pour exécuter des fonctionnalités de détection de défaut d'arc sur la base desdits premiers signaux (DS) ;
ledit second agencement d'enroulement étant adapté pour recevoir et injecter des signaux de commande d'arrêt en courant alternatif (CS) pour les dispositifs d'arrêt (22) desdites chaînes photovoltaïques, lesdits signaux de commande étant injectés en parallèle le long de toutes les lignes électriques à courant continu (30) couplées audit transformateur de couplage,
ledit onduleur comprenant en outre un agencement de commande d'arrêt (8) couplé fonctionnellement dudit second agencement d'enroulement (6) et comprenant un module de commande d'arrêt (80) couplé fonctionnellement audit second agencement d'enroulement (6) et adapté pour fournir lesdits signaux de commande d'arrêt (CS),
ledit module de commande d'arrêt (80) étant configuré pour transmettre en continu lesdits signaux de commande d'arrêt (CS) pendant le fonctionnement normal de ladite centrale photovoltaïque (100) et pour interrompre la transmission desdits signaux de commande d'arrêt, lorsque l'arrêt de panneaux photovoltaïques (21) de ladite centrale photovoltaïque est nécessaire.

2. Onduleur selon la revendication 1, **caractérisé en ce que** ledit agencement de détection de défaut d'arc (7) comprend un premier module de filtrage (71) adapté pour filtrer les composantes de signal en courant alternatif desdits premiers signaux (DS), qui ont des fréquences non comprises dans une bande de fréquences donnée.

3. Onduleur selon l'une des revendications précédentes, **caractérisé en ce que** ledit agencement de commande d'arrêt (8) comprend un second module de filtrage (82) adapté pour filtrer les composantes de signal haute fréquence desdits signaux de commande d'arrêt (CS).

4. Onduleur selon la revendication 3, **caractérisé en ce que** ledit agencement de commande d'arrêt (8) comprend un troisième module de filtrage (83) adapté pour filtrer les composantes de signal en courant continu desdits signaux de commande d'arrêt (CS).

5. Onduleur selon l'une des revendications 3 à 4, **caractérisé en ce que** ledit agencement de commande d'arrêt (8) comprend un module adaptateur (81) adapté pour fournir des fonctionnalités frontales analogiques.

6. Onduleur selon l'une des revendications précédentes, **caractérisé en ce que** lesdits signaux de commande d'arrêt (CS) sont des signaux périodiques, une période (T) desdits signaux de commande d'arrêt incluant une sous-période active (T_{T}), lesdits signaux de commande d'arrêt incluant une composante de signal modulée par BFSK, et une sous-période de secours (T_{Q}), lesdits signaux de commande de mise hors tension incluant une composante de signal nulle, la durée de ladite sous-période active (T_{T}) et de ladite sous-période de secours (T_{Q}) étant calculée en fonction d'une valeur de rapport cyclique (DC) prédéfinie.

7. Onduleur selon l'une des revendications précédentes, **caractérisé en ce que** ledit second agencement d'enroulement (6) est adapté pour injecter des signaux de test en courant alternatif (TS) le long des conducteurs de ligne desdites lignes électriques à courant continu.

8. Onduleur selon la revendication 7, **caractérisé en ce que** ledit module de détection de défaut d'arc (70) est adapté pour fournir lesdits signaux de test en courant alternatif (TS) audit second agencement d'enroulement (6).

9. Onduleur selon une ou plusieurs des revendications précédentes, **caractérisé en ce que** ledit second agencement d'enroulement (6) comprend un second conducteur d'enroulement (62) adapté pour fournir lesdits premiers signaux (DS) indicatifs de courants alternatifs circulant le long desdites lignes électriques à courant continu (30) et un troisième conducteur d'enroulement (63) adapté pour échanger lesdits seconds signaux (CS, TS) le long des conducteurs de lignes (31, 32) desdites lignes électriques à courant continu (30).

10. Centrale photovoltaïque (100), **caractérisée en ce qu'**elle comprend un onduleur (1) selon l'une des revendications précédentes.
